# FASCICULE DE BREVET EUROPEEN

(11) **EP 3 401 915 B1**
(45) Date de publication et mention de la délivrance du brevet: **09.12.2020**
(21) Numéro de dépôt: 18170980.9
(22) Date de dépôt: 07.05.2018
(51) Int. Cl.: G11C 13/00, G11C 29/02

(54) **PROCÉDÉ DE GESTION DE L'ENDURANCE D'UNE MEMOIRE REINSCRIPTIBLE NON VOLATILE ET DISPOSITIF DE PROGRAMMATION D'UNE TELLE MEMOIRE**
VERFAHREN ZUR STEUERUNG DER LEBENSDAUER EINES NICHT-FLÜCHTIGEN ÜBERSCHREIBBAREN SPEICHERS, UND PROGRAMMIERUNGSVORRICHTUNG EINES SOLCHEN SPEICHERS
METHOD FOR MANAGING THE ENDURANCE OF A NON-VOLATILE REWRITABLE MEMORY AND DEVICE FOR PROGRAMMING SUCH A MEMORY

(30) Priorité: 09.05.2017 FR 1754043
(43) Date de publication de la demande: 14.11.2018
(73) Titulaire: Commissariat à l'Energie Atomique et aux Energies Alternatives, 75015 Paris (FR)
(72) Inventeur: MOLAS, Gabriel, 38000 GRENOBLE (FR); HARRAND, Michel, 38120 SAINT-EGREVE (FR); VIANELLO, Elisa, 38000 GRENOBLE (FR); NAIL, Cécile, 38000 GRENOBLE (FR)
(74) Mandataire: Cabinet Camus Lebkiri

(56) Documents cités:
- US-A1- 2010 284 212
- US-A1- 2013 058 153
- US-A1- 2014 029 330
- US-B1- 9 558 823

## Description

### DOMAINE TECHNIQUE

La présente invention concerne un procédé de gestion de l'endurance d'une mémoire réinscriptible non volatile. L'invention concerne également un dispositif de programmation d'une telle mémoire réinscriptible non volatile.

L'invention trouve des applications dans le domaine des mémoires réinscriptibles non volatiles et, plus spécifiquement, celui des mémoires résistives de type OxRRAM (« Oxyde-based Resistive RAM») et CBRAM (« Conductive Bridging RAM »).

### ETAT DE LA TECHNIQUE

Dans le domaine des mémoires réinscriptibles non volatiles, différents types de mémoires sont utilisés en fonction des applications et des performances visées. Les mémoires les plus couramment utilisées, en particulier dans les appareils photos numériques, les téléphones cellulaires, les ordinateurs portables, les clés USB, et autres dispositifs portables, sont des mémoires appelées « mémoires Flash ». Les mémoires flash offrent, notamment, une forte densité d'intégration, une grande résistance aux chocs et une bonne durabilité.

La plupart des mémoires Flash non-volatiles du commerce utilisent le stockage de charges comme principe de codage de l'information. En pratique, une couche de piégeage de charge (généralement du polysilicium, ou un diélectrique comme le SiN) est encapsulée entre deux diélectriques dans l'empilement de grille d'un transistor MOS. La présence ou l'absence de charge dans ce médium modifie la conduction du transistor MOS et permet de coder l'état de la mémoire.

Toutefois, l'évolution de la microélectronique nécessite une miniaturisation toujours plus poussée des composants et, en particulier, des mémoires réinscriptibles non volatiles. Or, la miniaturisation de la technologie Flash est limitée, notamment par le fait que l'épaisseur de la couche de piégeage de charge ne peut être réduite en dessous d'une valeur minimale (de l'ordre de 6nm) sous peine de diminuer le temps de rétention de l'information.

Récemment, un nouveau type de mémoires, appelées mémoires résistives, ont fait leur apparition pour remplacer les mémoires Flash. Ces mémoires résistives ne reposent pas sur le piégeage de charge des grilles de transistors, mais sur un changement d'état d'un bloc résistif. Les mémoires résistives, notamment les mémoires résistives à base d'oxyde, nommées OxRRAM, et les mémoires résistives à base de matériau à conduction ionique, nommées CBRAM, sont basées sur un changement de l'état de résistance (forte ou faible résistance) d'un matériau actif intégré entre deux électrodes métalliques. Ce nouveau type de mémoire permet, non seulement une forte densité d'intégration, mais également une vitesse de fonctionnement élevée, une grande endurance et une bonne compatibilité avec les procédés de fabrication utilisés actuellement dans l'industrie microélectronique, en particulier avec les procédés de fin de ligne de la technologie CMOS.

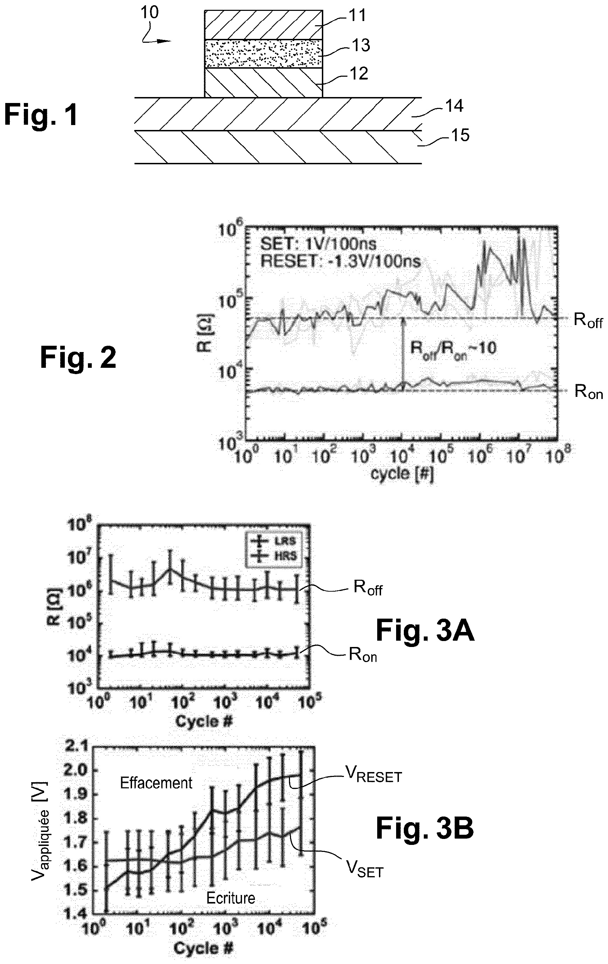

Une mémoire résistive comprend généralement une pluralité de cellules mémoire, appelées également points mémoire. Chaque cellule mémoire 10 comporte un empilement d'une première et d'une seconde électrodes, généralement en métal, et d'une couche en matériau actif, par exemple un oxyde de métal, disposé entre les deux électrodes. Un exemple d'une cellule mémoire résistive est représenté sur la figure 1. Cette mémoire résistive comporte une première électrode 11, une seconde électrode 12 et une couche en matériau diélectrique 13 agencée entre les première et seconde électrodes. La seconde électrode 12 de la mémoire résistive est ménagée au contact d'un substrat connecteur 14 assurant un contact électrique entre un dispositif de programmation et l'empilement. Le dispositif de programmation permet de contrôler les conditions de programmation, par exemple la tension de programmation, appliquées aux électrodes 11 et 12 de l'empilement.

La couche en matériau diélectrique13, appelée également couche active, est apte à commuter, de manière réversible, entre deux états de résistance qui correspondent aux valeurs logiques « 0 » et « 1 » utilisées pour coder un bit d'information. Ainsi, un empilement de mémoire résistive peut basculer d'un état faiblement résistif LRS (« Low Résistance State » en termes anglo-saxons) à un état fortement résistif HRS (« High Résistance State » en termes anglo-saxons) par l'application d'une première tension VRESET entre la première 11 et la seconde 12 électrodes, et rebasculer de l'état fortement résistif HRS à l'état faiblement résistif LRS par l'application d'une deuxième tension VSET entre les première et seconde électrodes. En particulier, une information est écrite dans la cellule mémoire en basculant la couche en matériau diélectrique de l'état fortement résistif HRS, appelé également état « OFF », à l'état faiblement résistif LRS, ou état « ON ». À l'inverse, une information peut être effacée de la cellule mémoire en basculant la couche en matériau diélectrique de l'état LRS vers l'état HRS. L'opération d'écriture dans la cellule mémoire est appelée « SET » ; l'opération d'effacement de ladite cellule mémoire est appelée « RESET ».

Ainsi, lors d'une opération d'écriture, le matériau diélectrique comporte une première valeur de résistance et, lors d'une opération d'effacement, il comporte une deuxième valeur de résistance, inférieure à la première valeur de résistance. Le changement de résistance du matériau diélectrique est gouverné par la formation et la rupture d'un filament conducteur de section nanométrique entre les deux électrodes 11-12. En l'état actuel des connaissances, ce filament semble être dû à des phénomènes différents, dépendant du type de matériau utilisé pour la couche de matériau actif. En particulier, dans une mémoire résistive de type OxRRAM dans laquelle la couche de matériau diélectrique est à base d'oxyde, le changement d'état résistif semble s'expliquer par la formation d'un filament de lacunes d'oxygène au sein de ladite couche de matériau diélectrique. Dans une mémoire résistive de type CBRAM, dans laquelle la couche de matériau diélectrique comporte un matériau à conduction ionique formant un électrolyte solide à conduction ionique disposé entre une électrode formant une cathode inerte et une électrode comportant une portion de métal ionisable, le changement d'état résistif semble s'expliquer par la formation d'un filament conducteur au sein de la couche de matériau diélectrique.

Divers documents décrivent des mémoires résistives. Par exemple, le document US 2013/0058153 A1 divulgue un procédé de fonctionnement d'une mémoire résistive et le document US 2015/243353 A1 divulgue une méthode pour programmer une mémoire résistive.

Toutefois, dans les mémoires résistives, il existe une certaine variabilité des niveaux de résistances, tant à l'état faiblement résistif LRS qu'à l'état fortement résistif HRS. En effet, à chaque opération d'écriture et d'effacement de la mémoire, les valeurs de la résistance Roff à l'état fortement résistif HRS et les valeurs de la résistance Ron à l'état faiblement résistif LRS fluctuent, comme représenté par les courbes de fluctuation des résistances Roff et Ron de la figure 2.

En outre, au fur et à mesure des cycles d'écriture et d'effacement de la mémoire, les niveaux des résistances du matériau diélectrique dérivent, s'écartant de plus en plus des valeurs de résistance des premiers cycles, comme montré sur la figure 2. Du fait de ces dérives, les conditions d'écriture et d'effacement - par exemple la tension d'écriture ou la tension d'effacement - doivent être modifiées pour permettre l'écriture ou l'effacement d'un matériau diélectrique. Ces modifications consistent généralement à appliquer une tension très forte ou, au contraire, très faible. Or, l'application de conditions d'écriture ou d'effacement trop faibles empêche toute écriture et l'application de conditions d'écriture ou d'effacement trop fortes génère des défauts dans le matériau diélectrique, ce qui dégrade ledit matériau diélectrique. Les performances des mémoires résistives ont donc tendance à se dégrader de plus en plus au fil des cycles d'écriture et d'effacement. Les performances en endurance de ces mémoires sont donc relativement restreintes.

Pour remédier à ce problème d'endurance et ainsi allonger la durée de vie des mémoires résistives, il est connu d'utiliser un procédé dit de « smart programming » qui a pour objectif de compenser les défauts accumulés au cours de plusieurs cycles d'écriture et d'effacement de la mémoire. Pour cela, le procédé de smart programming propose d'appliquer une tension de programmation qui augmente progressivement d'une valeur volontairement trop faible jusqu'à une valeur où le matériau diélectrique atteint une valeur de résistance cible. Autrement dit, ce procédé propose de déterminer une valeur de résistance cible considérée comme la valeur de résistance optimale à atteindre. Une tension de compensation - ou une durée ou un nombre d'impulsions à niveau de tension constant - destinée à réduire la probabilité de générer beaucoup de défauts dans le matériau diélectrique, est ensuite appliquée depuis une valeur faible qui est augmentée pas par pas jusqu'à ce que la résistance atteigne la valeur cible prédéterminée. Les conditions de compensation (tension ou durée d'impulsion) sont appliquées pour limiter les défauts au sein du matériau diélectrique aussi bien dans son état faiblement résistif que dans son état fortement résistif.

Les figures 3A et 3B représentent des courbes montrant l'évolution, respectivement, des valeurs de résistances du matériau diélectrique et des valeurs de la tension de compensation appliquée à la mémoire, au cours d'un grand nombre de cycles d'écriture et d'effacement, lorsqu'un procédé de smart programming est utilisé. On comprend de ces courbes que, lorsqu'une tension de compensation en écriture (courbe « set ») et en effacement (courbe « reset ») est appliquée, la valeur des résistances à l'état HRS et à l'état LRS du matériau diélectrique augmente. Cependant, cette augmentation des valeurs de résistance n'est que momentanée, les valeurs de résistances diminuant à nouveau rapidement au cours des cycles suivant l'application de la tension de compensation. En effet, la compensation en tension n'étant réalisée généralement qu'après un certain nombre de cycles - par exemple aux environs de 10² et 10⁴ cycles sur les figures 3A-3B - la mémoire est déjà fortement détériorée lorsque la tension de compensation est appliquée. Cette compensation en écriture et en effacement camouffle donc les défauts générés au fur et à mesure des cycles d'écriture et d'effacement, sans toutefois les réparer. En effet, les défauts du matériau diélectrique à l'origine de la modification des niveaux résistifs du matériau diélectrique sont irréversibles. Il n'est donc pas possible de les réparer, mais uniquement de les compenser en écrivant de plus en plus fort - et donc en dégradant de plus en plus le matériau diélectrique.

En effet, l'application de fortes conditions de compensation en écriture et en effacement, dans le but de compenser les défauts générés dans le matériau diélectrique, a pour effet de générer de nouveaux défauts au sein dudit matériau diélectrique.

### RESUME DE L'INVENTION

L'invention présente est définie par l'objet des revendications indépendantes. D'autres modes de réalisation préférés sont définis par l'objet des revendications dépendantes. Pour répondre au problème évoqué ci-dessus de la compensation des défauts dans le matériau diélectrique, le demandeur propose un procédé de gestion de l'endurance d'une mémoire résistive dans lequel les conditions d'écriture de la mémoire à appliquer durant le cycle à venir (ou cycle suivant) sont déterminées en fonction des conditions d'effacement appliquées durant le cycle précédent, de sorte à limiter les dérives de résistance du matériau diélectrique à chaque cycle et, ainsi, ralentir la dégradation de la mémoire.

Selon un premier aspect, l'invention concerne un procédé de gestion de l'endurance d'une mémoire réinscriptible non-volatile comprenant une pluralité de cellules mémoire comportant chacune un empilement ordonné d'une électrode inférieure, d'une couche de matériau diélectrique et d'une électrode supérieure, le matériau diélectrique de chaque empilement étant apte à commuter entre :
- un état fortement résistif, et
- un état faiblement résistif,
une commutation entre l'état fortement résistif et l'état faiblement résistif autorisant une écriture dans la cellule mémoire et une commutation entre l'état faiblement résistif et l'état fortement résistif autorisant un effacement dans ladite cellule mémoire,

Ce procédé se caractérise par le fait qu'il comporte les opérations suivantes :
- à la fin de chaque cycle d'écriture et d'effacement de la cellule mémoire, lecture de conditions d'effacement de ladite cellule mémoire au cours de la dernière opération d'effacement du cycle, et comparaison desdites conditions d'effacement lues avec une valeur d'effacement médiane prédéterminée correspondant à une valeur de résistance médiane qui suit une loi de dépendance prédéterminée reliant la condition d'effacement d'un cycle à la condition d'écriture d'un cycle suivant ; et
- détermination de conditions d'écriture de la cellule mémoire à partir des résultats de la comparaison, les conditions d'écriture au cycle suivant étant définies en fonction des conditions d'effacement du cycle précédent et de la loi de dépendance lesdites conditions d'écriture étant appliquées aux électrodes de l'empilement lors des opérations d'écriture du cycle d'écriture et d'effacement suivant afin de limiter la génération de défauts dans le matériau diélectrique.

Le fait d'ajuster les conditions d'écriture de la cellule mémoire permet de ralentir la génération des défauts dans le matériau diélectrique à chaque cycle d'écriture et d'effacement et, ainsi, de stabiliser les dérives de résistance de chaque cellule mémoire de la mémoire résistive. Cette stabilité des dérives de résistance augmente l'endurance de la mémoire et donc sa durée de vie.

La loi de dépendance peut être calibrée préalablement à tout cycle d'écriture et d'effacement. Cette loi de dépendance permet d'adapter le procédé de l'invention à tous types de mémoires résistives, chaque type de mémoire résistive ayant sa propre loi de dépendance.

Selon une variante, les conditions d'écriture comprennent une valeur de tension d'écriture appliquée entre les électrodes de chaque cellule mémoire, pendant une durée constante, pour que le matériau diélectrique commute de l'état fortement résistif à l'état faiblement résistif.

Selon une autre variante, les conditions d'écriture comprennent une durée d'application d'une tension de valeur constante entre les électrodes de chaque cellule mémoire, pour que le matériau diélectrique commute de l'état fortement résistif à l'état faiblement résistif.

Selon certains modes de réalisation, chaque cycle d'écriture et d'effacement comporte un ensemble alterné d'au moins une opération d'écriture et au moins une opération d'effacement. Ainsi, le terme « cycle » définit un ensemble constitué d'au moins une opération d'écriture et au moins une opération d'effacement d'une donnée d'une cellule mémoire de la mémoire résistive, une opération d'écriture succédant à chaque opération d'effacement. Dans un des modes de réalisation, le cycle d'écriture et d'effacement comporte une seule opération d'écriture et une seule opération d'effacement. Ce mode de réalisation offre une bonne précision dans la détermination des conditions d'écriture. Dans un autre mode de réalisation, le cycle d'écriture et d'effacement comporte plusieurs opérations d'écriture et plusieurs opérations d'effacement, une opération d'effacement alternant avec une opération d'écriture. Ce mode de réalisation offre un compromis entre précision et rapidité de programmation.

Avantageusement, les conditions d'effacement lues sont mémorisées au moins partiellement jusqu'au cycle d'écriture et d'effacement suivant, dans au moins une cellule mémoire de la mémoire réinscriptible non-volatile.

Selon un second aspect, l'invention concerne un dispositif de programmation d'une mémoire réinscriptible non-volatile mettant en oeuvre le procédé ci-dessus.

Selon certains modes de réalisation, le circuit de programmation comporte une pluralité de générateurs de tension aptes à générer chacun au moins une valeur de tension d'écriture et/ou d'effacement.

Selon d'autres modes de réalisation, le circuit de programmation comporte au moins un générateur de tension connecté à des ponts diviseurs.

Ces différents modes de réalisation permettent de faire varier la tension d'écriture et/ou d'effacement afin que la tension appliquée aux électrodes soit la plus proche possible de la valeur de tension déterminée.

Selon encore d'autres modes de réalisation, le circuit de programmation comporte au moins un générateur de tension connecté à au moins un compteur et/ou une horloge apte à moduler une durée d'application d'une tension constante sur les électrodes.

Ces modes de réalisation permettent de faire varier les conditions d'écriture et d'effacement avec un circuit simple et peu couteux.

### BREVE DESCRIPTION DES FIGURES

D'autres avantages et caractéristiques de l'invention apparaîtront à la lecture de la description, illustrée par les figures dans lesquelles :
- La figure 1, déjà décrite, représente schématiquement un exemple d'une cellule mémoire d'une mémoire résistive ;
- La figure 2, déjà décrite, représente des exemples d'évolution des résistances Roff et Ron d'une cellule mémoire au cours des cycles ;
- Les figures 3A et 3B, déjà décrites, représentent des exemples d'évolution des résistances Roff et Ron, en fonction des tensions d'écriture et d'effacement, lors d'une mise en œuvre du procédé de smart programming ;
- Les figures 4A et 4B représentent des exemples d'évolution et de distribution des résistances Roff et Ron, lors d'une mise en œuvre du procédé selon l'invention ;
- La figure 5 représente un exemple d'une loi de dépendance utilisée dans le procédé selon l'invention ;
- Les figures 6A et 6B représentent schématiquement deux modes de mise en œuvre de l'ajustement des conditions d'écriture du procédé de l'invention ;
- La figure 7 représente un exemple d'une loi de dépendance LD construite expérimentalement pour une mémoire CBRAM particulière.

### DESCRIPTION DETAILLEE D'AU MOINS UN MODE DE REALISATION

Un exemple d'un procédé de gestion de l'endurance d'une mémoire résistive est décrit en détail ci-après, en référence aux dessins annexés. Cet exemple illustre les caractéristiques et avantages de l'invention. Il est toutefois rappelé que l'invention ne se limite pas à cet exemple.

Sur les figures, les éléments identiques sont repérés par des références identiques. Pour des questions de lisibilité des figures, les échelles de taille entre éléments représentés ne sont pas respectées.

Le procédé de gestion de l'endurance selon l'invention est mis en œuvre dans une mémoire résistive comportant une pluralité de cellules mémoires, du type de celui représenté sur la figure 1 décrite précédemment. Chaque cellule mémoire 10 comporte un empilement ordonné, formé d'une électrode inférieure 12, d'une électrode supérieure 11 et d'une couche de matériau diélectrique 13. Cet empilement est associé à un circuit de programmation 15 apte à appliquer une différence de potentiel entre les deux électrodes 11 et 12. Plusieurs cellules mémoire 10 sont agencées les unes à côté des autres, sur un ou plusieurs étages, pour former une mémoire résistive.

La couche de matériau diélectrique 13, par exemple une couche en Oxyde de Hafnium (HfO₂), est capable de passer d'un état faiblement résistif LRS à un état fortement résistif HRS, et inversement, sous l'effet d'une tension appliquée entre les électrodes supérieure et inférieure. A l'état faiblement résistif, le matériau diélectrique a une résistance Ron ; à l'état fortement résistif, le matériau diélectrique a une résistance Roff, supérieure à Ron. Une commutation du matériau diélectrique de l'état fortement résistif HRS à l'état faiblement résistif LRS permet d'écrire une donnée ; une commutation du matériau diélectrique de l'état faiblement résistif LRS à l'état fortement résistif HRS permet d'effacer la donnée. Chaque phase d'effacement d'une donnée de la cellule mémoire succède à une phase d'écriture de ladite donnée. Un ensemble alterné de phases d'écriture et de phases d'effacement forment un cycle d'écriture et d'effacement. Un cycle d'écriture et d'effacement, appelé aussi cycle, peut ainsi comporter une phase d'écriture suivie d'une phase d'effacement ; il peut également comporter une alternance de plusieurs phases d'écriture et plusieurs phases d'effacement.

Le procédé de l'invention propose de limiter les dérives des résistances Roff et Ron à chaque cycle de façon à diminuer, voir empêcher, la formation de défauts dans le matériau diélectrique 13. Pour cela, le procédé de l'invention propose de déterminer les conditions d'écriture à appliquer à un cycle en fonction des conditions d'effacement appliquées au cycle précédent. En effet, le fait d'écrire dans la cellule mémoire avec des conditions d'écriture établies en fonction des conditions d'effacement du cycle précédent permet à la résistance Ron du matériau diélectrique à l'état faiblement résistif LRS de fluctuer autour d'une valeur de résistance médiane Ronmed. Dans la mesure où la résistance Ron fluctue autour d'une valeur de résistance médiane Ronmed et dans la mesure où la valeur de résistance Roff du matériau diélectrique à l'état fortement résistif HRS est déterminée pour chaque cycle - comme expliqué par la suite - la valeur de la résistance Roff fluctue autour d'une valeur de résistance médiane Roffmed.

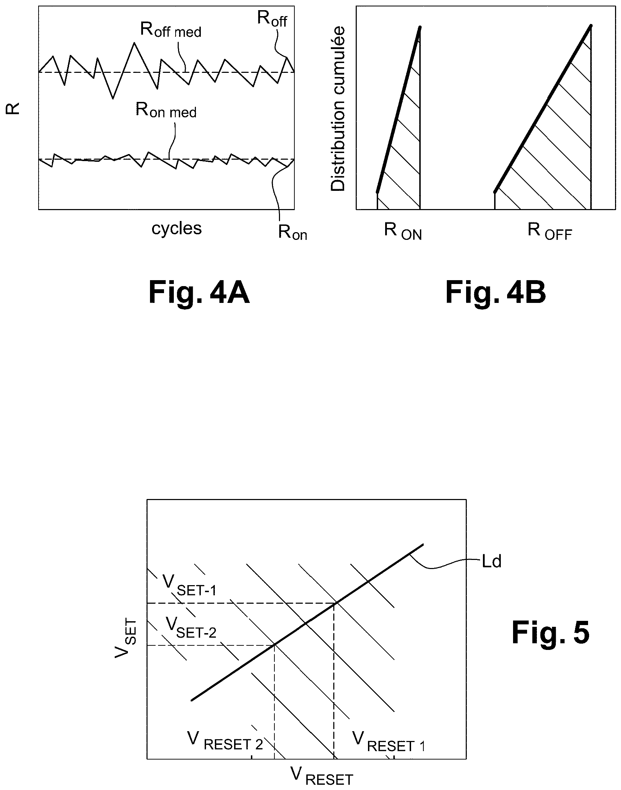

La figure 4A représente des exemples de fluctuation des résistances Ron et Roff d'une même cellule mémoire, sur plusieurs cycles. La figure 4B représente des exemples de la distribution cumulée des valeurs des résistances Ron et Roff. En particulier, la figure 4A représente la courbe des valeurs de résistance Roff qui fluctuent autour d'une première valeur de résistance médiane Roffmed et la courbe des valeurs de résistance Ron qui fluctuent autour d'une deuxième valeur de résistance médiane Ronmed.

Le filament au sein du matériau diélectrique ayant une forme variable à la fin de chaque opération d'écriture et opération d'effacement, la résistance dudit matériau diélectrique, qui dépend de la fluctuation du filament, a des valeurs stochastiques, aussi bien à l'état fortement résistif qu'à l'état faiblement résistif. Le procédé de l'invention propose d'ajuster les conditions d'écriture à appliquer durant la ou les opérations d'écriture du prochain cycle en fonction des conditions d'effacement appliquées durant la dernière opération d'effacement du cycle précédent, de sorte à compenser, à chaque cycle, les fluctuations dudit filament. Ainsi, le fait de déterminer, à chaque cycle, les conditions d'écriture à utiliser à l'opération d'écriture suivante permet d'écrire les données avec des conditions d'écriture optimales qui limitent la génération de défauts dans la cellule mémoire.

L'ajustement des conditions d'écriture à appliquer au cycle suivant est réalisé en comparant les conditions d'effacement appliquées lors de la dernière opération d'effacement du cycle précédent avec une valeur d'effacement médiane prédéterminée. Cette valeur d'effacement médiane peut être la valeur d'effacement correspondant à la valeur de résistance médiane Ronmed représentée sur la figure 4A. La valeur d'effacement médiane suit une loi de dépendance Ld reliant les conditions d'écriture aux conditions d'effacement. Cette loi de dépendance permet, à partir des conditions d'effacement de la cellule mémoire appliquées à un cycle n-1, de définir les conditions d'écriture à appliquer au cycle suivant n. Les conditions d'écriture sont donc ajustées en fonction des conditions d'effacement lues. Un exemple d'une loi de dépendance Ld sera décrit plus en détail, par la suite, en relation avec la figure 5. Selon une variante, la loi de dépendance Ld peut être discrétisée ; la condition d'effacement est alors comparée avec une valeur médiane des conditions d'effacement et les conditions d'écriture à appliquer à l'opération d'écriture suivante sont déterminées en fonction de cette valeur médiane.

Selon certains modes de réalisation, les conditions d'écriture et d'effacement peuvent être une tension, respectivement, d'écriture et d'effacement, c'est-à-dire une différence de potentiel appliquée entre les deux électrodes d'un empilement pour permettre d'écrire ou d'effacer une donnée sur/de la cellule mémoire. Dans de tels modes de réalisation, la valeur de tension appliquée entre les électrodes est variable et la durée d'application de cette tension est constante. Selon d'autres modes de réalisation, les conditions d'écriture et d'effacement peuvent être la durée d'application de la tension aux électrodes - la durée pouvant correspondre également à un nombre d'impulsions appliquées aux électrodes. Dans ces modes de réalisation, la durée (ou le nombre d'impulsions) est variable et la valeur de la tension appliquée est constante. En effet, l'homme du métier comprendra que, du fait de l'équivalence connue dans le domaine des mémoires résistives entre le niveau de tension et la durée de la mise sous tension, il est possible d'appliquer aux électrodes, indifféremment, soit une tension de valeur constante avec une durée variable, soit une tension de valeur variable mais avec une durée constante.

Dans les exemples qui vont maintenant être décrits, les conditions d'écriture et/ou d'effacement seront la tension variable appliquée entre les électrodes d'une cellule mémoire, étant entendu que des exemples similaires pourraient être mis en œuvre avec une durée d'application (ou un nombre d'impulsions) variable et une valeur de tension constante.

La figure 5 représente un exemple d'une loi de dépendance Ld entre la tension d'effacement Vreset et la tension d'écriture Vset d'une cellule mémoire. Selon cet exemple, si la tension d'effacement lue à la fin du cycle n-1 a pour valeur Vreset1, alors la valeur de la tension d'écriture au cycle n sera Vset1, la valeur Vset1 étant définie en fonction de la valeur Vreset1 et de la loi de dépendance Ld. De même, si la tension d'effacement lue à la fin du cycle n-1 a pour valeur Vreset2, alors la valeur de la tension d'écriture, définie en fonction de la valeur Vreset2 et de la loi de dépendance Ld, sera Vset2 au cycle n. Ainsi, plus la valeur de la tension nécessaire à l'effacement d'une donnée au cours d'un cycle est élevée, plus la valeur de la tension nécessaire à l'écriture d'une donnée au cycle suivant sera élevée. Inversement, plus la valeur de la tension nécessaire à l'effacement d'une donnée au cours d'un cycle est basse, plus la valeur de la tension nécessaire à l'écriture d'une donnée au cycle suivant sera basse.

Le fait d'appliquer, à chaque cycle, une tension d'écriture en correspondance avec la tension d'effacement qu'il a fallu au cycle précédent pour atteindre la résistance cible (c'est-à-dire la résistance Roff permettant l'effacement) permet de limiter les défauts générés dans le matériau diélectrique en tenant compte de l'évolution stochastique de l'état de résistance du matériau diélectrique.

Pour optimiser le procédé de l'invention, il est préférable que la cellule mémoire soit effacée de façon optimale au cours du cycle précédent. Pour effacer la cellule mémoire de façon optimale, c'est-à-dire avec une valeur de résistance Roff adaptée à l'état du matériau diélectrique, plusieurs méthodes peuvent être mises en œuvre.

Par exemple, la méthode du smart programming, décrit dans l'état de la technique, peut être mise en œuvre de sorte à atteindre progressivement la valeur de résistance Roff à laquelle la cellule mémoire est effacée. Dès que la valeur Roff est atteinte, la valeur de la tension d'effacement permettant d'atteindre cette valeur de résistance Roff est lue et mémorisée pour être utilisée ultérieurement dans l'opération de détermination de la tension d'écriture.

D'autres méthodes peuvent également être mises en œuvre pour permettre d'effacer de façon optimale la cellule mémoire comme, par exemple, une méthode dans laquelle on détermine, à la fin de chaque cycle d'écriture et d'effacement, les conditions d'effacement qui seront mises en œuvre au cycle d'écriture et d'effacement suivant. Ces conditions d'effacement sont déterminées de sorte que, à l'état fortement résistif HRS, la résistance Roff du matériau diélectrique fluctue autour d'une valeur de résistance médiane Roffmed. Une telle méthode peut, par exemple, proposer de :
- lire, à la fin d'une opération d'écriture d'un cycle n-1, la valeur de résistance du matériau diélectrique ;
- comparer cette valeur de résistance lue à des valeurs de référence prédéterminées;
- déterminer des conditions d'effacement à partir du résultat de cette comparaison ;
- appliquer à la cellule mémoire, lors de l'opération d'effacement du cycle suivant n, les conditions d'effacement déterminées ;
- mémoriser ces conditions d'effacement, par exemple la valeur de la tension d'effacement permettant d'atteindre la valeur de résistance Roff, afin qu'elles puissent être utilisées ultérieurement dans l'opération de détermination de la tension d'écriture.

L'homme du métier comprendra que l'une ou l'autre des méthodes citées ci-dessus peut être mise en œuvre, de même que d'autres méthodes dès lors que ces autres méthodes permettent d'atteindre la valeur de résistance Roff la mieux adaptée à l'effacement de la donnée inscrite dans la cellule mémoire. La méthode à appliquer pour déterminer les conditions d'effacement peut être choisie, par exemple, en tenant compte d'éventuelles contraintes, telles que des contraintes de temps, de tension, d'algorithme, etc.

Les conditions d'effacement, par exemple la tension d'effacement, qui permettent d'atteindre la valeur de résistance Roff sont les données de base de la détermination des conditions d'écriture de la cellule mémoire au cours du prochain cycle. Ces conditions d'écriture au prochain cycle (ou cycle suivant) sont définies comme étant l'image des conditions d'effacement du cycle précédent par la loi de dépendance Ld.

La loi de dépendance Ld entre les conditions d'effacement et les conditions d'écriture est une loi prédéfinie, déterminée lors d'une étape de calibration préliminaire. La loi de dépendance diffère selon la technologie de la mémoire. Par exemple, une mémoire résistive de type OxRRAM avec une couche d'Oxyde de Hafnium comme matériau diélectrique présentera une loi de dépendance différente de celle d'une mémoire CBRAM avec une couche de Sulfure de Germanium. Chaque type de mémoire résistive répond donc à une loi de dépendance prédéterminée, enregistrée au sein de ladite mémoire pour permettre la détermination des conditions d'écriture.

Dans certains modes de réalisation, la loi de dépendance Ld relie la tension d'effacement d'un cycle avec la tension d'écriture d'un cycle suivant. Dans d'autres modes de réalisation, la loi de dépendance relie la durée d'application (ou le nombre d'impulsions) d'une tension d'écriture de valeur constante, avec la durée d'application (ou le nombre d'impulsions) d'une tension d'effacement de valeur constante.

Quel que soit le mode de réalisation, la loi de dépendance peut être déterminée par calculs, par exemple, par simulation en utilisant des modèles de RRAM. Cette loi de dépendance Ld peut également être déterminée expérimentalement, par des mesures successives.

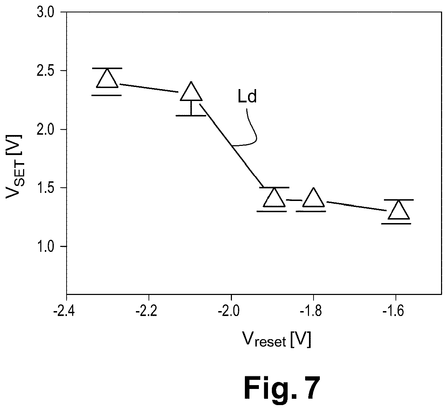

La loi de dépendance Ld peut, par exemple, être déterminée suivant la méthode expérimentale suivante : En partant de cellules écrites (état LRS), on applique différentes conditions d'effacement, par exemple différentes valeurs de tension Vreset ou de temps Treset. On atteint alors l'état HRS. Sur ces cellules effacées, on applique des impulsions d'écriture, avec un temps d'impulsion constant, en augmentant la tension d'écriture à chaque impulsion. La tension à partir de laquelle la cellule mémoire est écrite (donc bascule dans l'état LRS) est définie comme la tension d'écriture. Un exemple d'une courbe expérimentale de Vset en fonction de Vreset pour une mémoire CBRAM Al2O3/CuTe est représenté sur la figure 7. Cette courbe constitue un exemple de loi de dépendance Ld utilisée dans le procédé de l'invention.

Quelle que soit la loi de dépendance choisie, le procédé selon l'invention comporte les étapes suivantes :
- à la fin d'un cycle n-1, lecture de la valeur de la tension d'effacement appliquée durant la dernière opération d'effacement ;
- enregistrement de cette valeur de tension d'effacement dans au moins une cellule mémoire de la mémoire résistive ;
- détermination des conditions d'écriture à utiliser au cycle suivant n, à partir de la valeur de la tension d'effacement enregistrée et de la loi de dépendance prédéfinie ;
- application à la cellule mémoire des conditions d'écriture déterminées pour le cycle n.

Selon une variante, chaque cycle comporte une opération d'écriture et une opération d'effacement. Le procédé est alors mis en œuvre à la fin de chaque opération d'effacement afin de déterminer les conditions d'écriture pour chaque opération d'écriture. Cette variante a l'avantage d'offrir une grande précision dans la détermination des conditions d'écriture.

Selon une autre variante, chaque cycle comporte une alternance de plusieurs opérations d'écriture et plusieurs opérations d'effacement, par exemple dix opérations d'effacement et dix opérations d'écriture. Le procédé est alors mis en œuvre régulièrement après plusieurs opérations d'écriture et d'effacement alternées afin de déterminer les conditions d'écriture à appliquer à toutes les opérations d'écriture du cycle suivant. Cette variante a l'avantage d'être plus rapide que la variante précédente puisque les mêmes conditions d'écriture sont appliquées à plusieurs opérations d'écriture.

L'opération de lecture de la valeur des conditions d'effacement de la cellule mémoire au cycle précédent comporte une comparaison de cette valeur à des valeurs de référence. Ces valeurs de référence peuvent être générées dans un circuit de programmation décrit ultérieurement. Lorsque les conditions d'effacement sont la valeur de la tension d'effacement, la comparaison peut être effectuée au moyen de comparateurs connectés à des générateurs de tension tels que ceux décrits par la suite.

Comme expliqué précédemment, les conditions d'effacement lues au cycle précédent sont mémorisées dans des cellules mémoires de la mémoire résistive. Selon certains modes de réalisation, la place mémoire dédiée à la mise en œuvre du procédé de l'invention peut être optimisée en ne mémorisant, par exemple, que les conditions des cellules mémoires considérées comme les plus sensibles par l'utilisateur comme, par exemple, les cellules les plus souvent effacées et réécrites de la mémoire résistive et/ou les cellules mémoire utilisant les tensions de programmation les plus élevées

En effet, le procédé de l'invention - avec adaptation des conditions d'écriture - peut n'être mis en œuvre que pour une fraction de la mémoire totale, ce qui correspond à un nombre réduit de cellules mémoire. Ce nombre réduit de cellules mémoire peut être choisi, par l'utilisateur, comme les cellules sensibles.

Selon certains modes de réalisation, une mémoire associative est utilisée pour stocker les adresses et conditions d'effacement : la partie « tag » de cette mémoire associative peut, par exemple, être réalisée en ReRAM car écrite peu souvent. Les conditions d'effacement sont codées en SRAM, technologie non-sujette à l'usure. Le procédé de l'invention n'est utilisé que sur une faible portion de la mémoire car la taille des mémoires SRAM est supérieure à celle des ReRAM.

Selon certains modes de réalisation, la place mémoire dédiée à la mise en œuvre du procédé de l'invention peut être optimisée en utilisant les zones de mémoire cache de la mémoire résistive pour stocker momentanément les valeurs des conditions d'effacement et les utiliser au moment où la mémoire cache doit être vidée pour y stocker une autre donnée. La mémoire cache est alors utilisée pour stocker successivement plusieurs données de types différents.

Selon certains modes de réalisation, la place mémoire dédiée au stockage des conditions lues peut être optimisée en ne stockant qu'une tendance des conditions d'écriture à appliquer, cette tendance pouvant être plus ou moins précise. Par exemple, pour diminuer le nombre de cellules mémoire nécessaires au stockage des conditions lues, il est possible de coder, sur une seule cellule mémoire, les tendances « augmenter la tension d'écriture » et « diminuer la tension d'écriture ». En augmentant le nombre de cellules mémoire, la nuance de la tendance peut être affinée ; par exemple, en codant sur deux cellules mémoire, il est possible de coder les informations « appliquer la tension médiane + n% », « appliquer la tension médiane - n% », « appliquer la tension médiane + 2n% » et « appliquer la tension médiane - 2n% ».

La loi de dépendance doit également être stockée dans la mémoire résistive. Toutefois, comme cette loi de dépendance est valable pour toutes les cellules mémoire d'une même mémoire et pendant toute la durée de vie de ladite mémoire, elle n'a pas besoin d'être rafraichie et peut être stockée dans une zone de mémoire morte.

L'homme du métier comprendra qu'un nombre élevé de cellules mémoire dédiées à la mise en œuvre du procédé de l'invention permet de coder des conditions de programmation affinées. Il comprendra, en outre, que plusieurs des modes de réalisation décrits précédemment peuvent être mis en œuvre simultanément afin d'optimiser au mieux le ratio entre la place mémoire dédiée à la mise en œuvre du procédé et la précision de la détermination des conditions de programmation.

Le procédé selon l'invention peut être mis en œuvre dans un dispositif de programmation d'une mémoire résistive. Ce dispositif peut comporter un circuit de programmation, connecté aux électrodes supérieure et inférieure de chaque cellule mémoire de la mémoire.

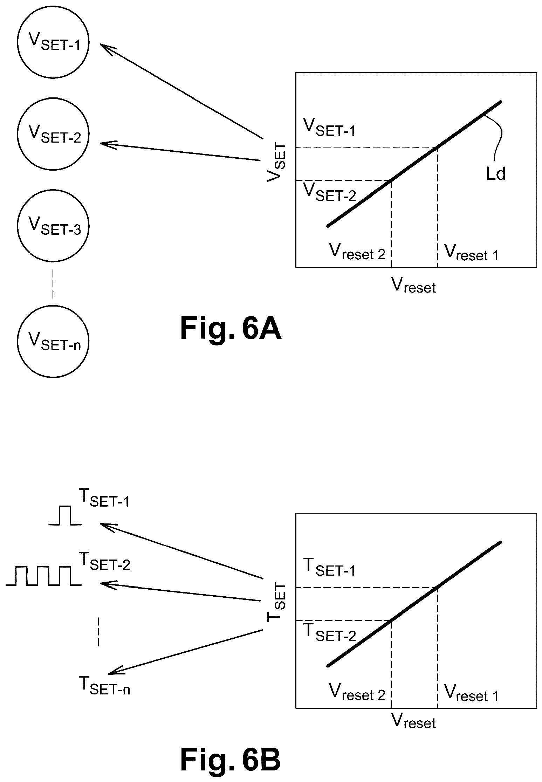

Selon certains modes de réalisation, le circuit de programmation comporte une pluralité de générateurs de tension aptes à délivrer chacun au moins une valeur de tension d'écriture et/ou d'effacement différente de la valeur de tension délivrée par les autres générateurs. En effet, pour appliquer les valeurs de tension d'écriture et/ou d'effacement déterminées par le procédé de l'invention, plusieurs générateurs de tension peuvent être nécessaires, comme représenté sur la figure 6A. Le circuit de programmation peut alors choisir, parmi les générateurs de tension, le nombre et la combinaison de ces générateurs qui permettent d'approcher au mieux la valeur de tension d'écriture ou d'effacement déterminée. Toutefois, afin de limiter le nombre de générateurs de tension, chaque générateur peut comporter des ponts diviseurs qui, par divisions d'une tension de référence, permettent d'appliquer aux électrodes la valeur de tension d'écriture et/ou d'effacement la plus proche de la valeur déterminée.

Selon certains autres modes de réalisation, le circuit de programmation comporte un seul (ou plusieurs) générateur(s) de tension délivrant (chacun) une valeur de tension constante. Ce générateur de tension est connecté à au moins un compteur et/ou une horloge aptes à contrôler la durée ou le nombre d'impulsions de tension constante à appliquer aux électrodes pour obtenir un résultat identique à celui qui aurait été obtenu avec une valeur de tension d'écriture et/ou d'effacement déterminée dans les modes de réalisation où la tension est variable. Un exemple d'application du nombre d'impulsions à une tension constante, déterminé avec le procédé selon l'invention, pour une opération d'écriture est représenté schématiquement sur la figure 6B.

Ainsi, le fait de déterminer, à chaque cycle, les conditions d'écriture à utiliser au cycle suivant, en correspondance avec les conditions d'effacement au cycle précédent, permet d'écrire les données avec des conditions optimales qui limitent la génération de défauts dans la cellule mémoire. Les défauts générés dans le matériau diélectrique sont donc compensés à chaque cycle, avant que la mémoire n'ait trop dérivé. En effet, le fait de compenser une dérive de la résistance du matériau diélectrique rapidement après la naissance de celle-ci permet de stabiliser l'état, respectivement, fortement ou faiblement résistif du matériau diélectrique.

Ainsi, le procédé selon l'invention permet de gérer l'endurance d'une mémoire résistive en déterminant, à chaque cycle, les conditions d'écriture de chaque cellule mémoire au cycle suivant. Le procédé selon l'invention permet ainsi d'améliorer l'endurance d'une mémoire résistive et, par conséquent, d'augmenter la durée de vie de ladite mémoire.

Bien que décrit à travers un certain nombre d'exemples, variantes et modes de réalisation, le procédé de gestion d'endurance selon l'invention et le dispositif de programmation mettant en œuvre ce procédé comprennent divers variantes, modifications et perfectionnements qui apparaîtront de façon évidente à l'homme du métier, étant entendu que ces variantes, modifications et perfectionnements font partie de la portée de l'invention, telle que définie par les revendications qui suivent.

## Revendications

1. Procédé de gestion de l'endurance d'une mémoire réinscriptible non-volatile comprenant une pluralité de cellules mémoire (10) comportant chacune un empilement ordonné d'une électrode inférieure (12), d'une couche de matériau diélectrique (13) et d'une électrode supérieure (11), le matériau diélectrique de chaque empilement étant apte à commuter entre :
- un état fortement résistif (HRS), et
- un état faiblement résistif (LRS),
une commutation entre l'état fortement résistif et l'état faiblement résistif autorisant une écriture dans la cellule mémoire et une commutation entre l'état faiblement résistif et l'état fortement résistif autorisant un effacement dans ladite cellule mémoire,
**caractérisé en ce qu'**il comporte les opérations de:
- à la fin de chaque cycle d'écriture et d'effacement de la cellule mémoire, lecture de conditions d'effacement (Roff) de ladite cellule mémoire au cours de la dernière opération d'effacement du cycle, et comparaison desdites conditions d'effacement lues avec une valeur d'effacement médiane prédéterminée correspondant à une valeur de résistance médiane (Roffmed) qui suit une loi de dépendance (Ld) prédéterminée reliant la condition d'effacement d'un cycle à la condition d'écriture d'un cycle suivant; et
- détermination de conditions d'écriture de la cellule mémoire (Vset, Tset) à partir des résultats de la comparaison, les conditions d'écriture au cycle suivant étant définies en fonction des conditions d'effacement du cycle précédent et de la loi de dépendance, lesdites conditions d'écriture étant appliquées aux électrodes (11, 12) de l'empilement lors des opérations d'écriture du cycle d'écriture et d'effacement suivant afin de limiter la génération de défauts dans le matériau diélectrique (13).

2. Procédé selon la revendication 1, **caractérisé en ce que** les conditions d'écriture comprennent une valeur de tension d'écriture (Vset) appliquée entre les électrodes (11, 12) de chaque cellule mémoire, pendant une durée constante, pour que le matériau diélectrique (13) commute de l'état fortement résistif (HRS) à l'état faiblement résistif (LRS).

3. Procédé selon la revendication 1, **caractérisé en ce que** les conditions d'écriture comprennent une durée d'application (Tset) d'une tension de valeur constante entre les électrodes (11, 12) de chaque cellule mémoire, pour que le matériau diélectrique (13) commute de l'état fortement résistif (HRS) à l'état faiblement résistif (LRS).

4. Procédé selon l'une quelconque des revendications 1 à 3, **caractérisé en ce que** la loi de dépendance (Ld) est calibrée préalablement à tout cycle d'écriture et d'effacement.

5. Procédé selon l'une quelconque des revendications 1 à 4, **caractérisé en ce que** chaque cycle d'écriture et d'effacement comporte un ensemble alterné d'au moins une opération d'écriture et au moins une opération d'effacement.

6. Procédé selon l'une quelconque des revendications 1 à 5, **caractérisé en ce que** les conditions d'effacement (Roff) lues sont mémorisées au moins partiellement jusqu'au cycle d'écriture et d'effacement suivant, dans au moins une cellule mémoire de la mémoire.

7. Dispositif de programmation d'une mémoire réinscriptible non-volatile comportant un circuit de programmation (15) connecté aux électrodes de chaque cellule mémoire (10), **caractérisé en ce qu'**il met en œuvre le procédé selon l'une quelconque des revendications 1 à 6.

8. Dispositif selon la revendication 7, **caractérisé en ce que** le circuit de programmation (15) comporte une pluralité de générateurs de tension aptes à générer chacun au moins une valeur de tension d'écriture et/ou d'effacement.

9. Dispositif selon la revendication 7, **caractérisé en ce que** le circuit de programmation (15) comporte au moins un générateur de tension connecté à des ponts diviseurs.

10. Dispositif selon la revendication 8 ou 9, **caractérisé en ce que** le circuit de programmation (15) comporte au moins un générateur de tension connecté à au moins un compteur et/ou une horloge apte à moduler une durée d'application d'une tension de valeur constante sur les électrodes.

## Patentansprüche

1. Verwaltungsverfahren der Haltbarkeit eines wiederbeschreibbaren, nicht flüchtigen Speichers, umfassend eine Vielzahl von Speicherzellen (10), von denen jede eine geordnete Stapelung einer unteren Elektrode (12), einer dielektrischen Materialschicht (13) und einer oberen Elektrode (11) umfasst, wobei das dielektrische Material jeder Stapelung geeignet ist, umzuschalten zwischen:
- einem stark ohmschen Zustand (HRS) und
- einem schwach ohmschen Zustand (LRS),
wobei ein Umschalten zwischen dem stark ohmschen Zustand und dem schwach ohmschen Zustand ein Schreiben in der Speicherzelle und ein Umschalten zwischen dem schwach ohmschen Zustand und dem stark ohmschen Zustand ein Löschen in der genannten Speicherzelle erlauben,
**dadurch gekennzeichnet, dass** es die Operationen umfasst:
- am Ende jedes Schreib- und Löschzyklus der Speicherzelle Lesen von Löschbedingungen (Roff) der genannten Speicherzelle im Verlauf der letzten Löschoperation des Zyklus und Vergleich der genannten gelesenen Löschoperationen mit einem medianen, vorbestimmten Löschwert, der einem medianen Widerstandswert (Roffmed) entspricht, der einem vorbestimmten Abhängigkeitsgesetz (Ld) folgt, das die Löschbedingung eines Zyklus mit der Schreibbedingung eines folgenden Zyklus verbindet; und
- Bestimmung von Schreibbedingungen der Speicherzelle (Vset, Tset) ausgehend von den Ergebnissen des Vergleichs, wobei die Schreibbedingungen im folgenden Zyklus in Abhängigkeit von den Löschbedingungen des vorherigen Zyklus und des Abhängigkeitsgesetzes definiert werden, wobei die genannten Schreibbedingungen auf die Elektroden (11, 12) der Stapelung bei den Schreibbedingungen des folgenden Schreib- und Löschzyklus angewendet werden, um das Erzeugen von Fehlern in dem dielektrischen Material (13) zu beschränken.

2. Verfahren gemäß Anspruch 1, **dadurch gekennzeichnet, dass** die Schreibbedingungen einen Wert der Schreibspannung (Vset) umfassen, der zwischen den Elektroden (11, 12) jeder Speicherzelle während einer konstanten Dauer angewendet wird, damit das dielektrische Material (13) vom stark ohmschen Zustand (HRS) in den schwach ohmschen Zustand (LRS) umschaltet.

3. Verfahren gemäß Anspruch 1, **dadurch gekennzeichnet, dass** die Schreibbedingungen eine Anwendungsdauer (Tset) einer Spannung des konstanten Wertes zwischen den Elektroden (11, 12) jeder Speicherzelle umfassen, damit das dielektrische Material (13) vom stark ohmschen Zustand (HRS) in den schwach ohmschen Zustand (LRS) umschaltet.

4. Verfahren gemäß irgendeinem der Ansprüche 1 bis 3, **dadurch gekennzeichnet, dass** das Abhängigkeitsgesetz (Ld) vor jedem Schreib- und Löschzyklus geeicht wird.

5. Verfahren gemäß irgendeinem der Ansprüche 1 bis 4, **dadurch gekennzeichnet, dass** jeder Schreib- und Löschzyklus eine abwechselnde Gruppe wenigstens einer Schreiboperation und wenigstens einer Löschoperation umfasst.

6. Verfahren gemäß irgendeinem der Ansprüche 1 bis 5, **dadurch gekennzeichnet, dass** die gelesenen Löschbedingungen (Roff) wenigstens teilweise bis zum folgenden Schreib- und Löschzyklus in wenigstens einer Speicherzelle des Speichers gespeichert werden.

7. Programmvorrichtung eines wiederbeschreibbaren, nicht flüchtigen Speichers, umfassend eine Programmierschaltung (15), die an die Elektroden jeder Speicherzelle (10) angeschlossen ist, **dadurch gekennzeichnet, dass** sie das Verfahren gemäß irgendeinem der Ansprüche 1 bis 6 umsetzt.

8. Vorrichtung gemäß Anspruch 7, **dadurch gekennzeichnet, dass** die Programmierschaltung (15) eine Vielzahl von Spannungserzeugern umfasst, die geeignet sind, jeweils wenigstens einen Wert der Schreib- und / oder Lösch-Spannung zu erzeugen.

9. Vorrichtung gemäß Anspruch 7, **dadurch gekennzeichnet, dass** die Programmierschaltung (15) wenigstens einen Spannungserzeuger umfasst, der an Spannungsteiler-Punkte angeschlossen ist.

10. Vorrichtung gemäß Anspruch 8 oder 9, **dadurch gekennzeichnet, dass** die Programmierschaltung (15) wenigstens einen Spannungserzeuger, der an wenigstens einen Zähler angeschlossen ist, und / oder eine Zeituhr, die geeignet ist, eine Anwendungsdauer einer Spannung eines konstanten Wertes auf den Elektroden zu modulieren, umfasst.

## Claims

1. Method for managing the endurance of a non-volatile rewritable memory including a plurality of memory cells (10) each comprising an ordered stack of a lower electrode (12), a layer of dielectric material (13) and an upper electrode (11), the dielectric material of each stack being capable of switching between:
- a high resistance state (HRS), and
- a low resistance state (LRS),
a switching between the high resistance state and the low resistance state allowing a writing in the memory cell and a switching between the low resistance state and the high resistance state allowing an erasure in said memory cell,
**characterised in that** it comprises the operations of:
- at the end of each writing and erasure cycle of the memory cell, reading the erasure conditions (Roff) of said memory cell in the course of the final erasure operation of the cycle, and comparing said read erasure conditions with a predetermined median erasure value corresponding to a median resistance value (Roffmed) which follows a predetermined dependency law (Ld) linking the erasure condition of a cycle with the writing condition of a following cycle; and
- determining the writing conditions of the memory cell (Vset, Tset) from the results of the comparison, said writing conditions being defined according to the erasure conditions of the previous cycle and the dependency law, said writing conditions being applied to the electrodes (11, 12) of the stack during writing operations of the following writing and erasure cycle in order to limit the generation of defects in the dielectric material (13).

2. Method according to claim 1, **characterised in that** the writing conditions include a writing voltage value (Vset) applied between the electrodes (11, 12) of each memory cell, for a constant duration, so that the dielectric material (13) switches from the high resistance state (HRS) to the low resistance state (LRS).

3. Method according to claim 1, **characterised in that** the writing conditions include a duration of application (Tset) of a voltage of constant value between the electrodes (11, 12) of each memory cell, so that the dielectric material (13) switches from the high resistance state (HRS) to the low resistance state (LRS).

4. Method according to any of claims 1 to 3, **characterised in that** the dependency law (Ld) is calibrated prior to any writing and erasure cycle.

5. Method according to any of claims 1 to 4, **characterised in that** each writing and erasure cycle comprises an alternating series of at least one writing operation and at least one erasure operation.

6. Method according to any of claims 1 to 5, **characterised in that** the read erasure conditions (Roff) are memorised at least partially up to the following writing and erasure cycle, in at least one memory cell of the memory.

7. Device for programming a non-volatile rewritable memory comprising a programming circuit (15) connected to the electrodes of each memory cell (10), **characterised in that** it implements the method according to any of claims 1 to 6.

8. Device according to claim 7, **characterised in that** the programming circuit (15) comprises a plurality of voltage generators each capable of generating at least one writing and/or erasure voltage value.

9. Device according to claim 7, **characterised in that** the programming circuit (15) comprises at least one voltage generator connected to dividing bridges.

10. Device according to claim 8 or 9, **characterised in that** the programming circuit (15) comprises at least one voltage generator connected to at least one counter and/or one clock capable of modulating a duration of application of a voltage of constant value to the electrodes.
